# EUROPEAN PATENT APPLICATION

(11) **EP 4 773 769 A1**
(43) Date of publication of application: **08.07.2026**
(21) Application number: 24906409.8
(22) Date of filing: 18.12.2024
(51) Int. Cl.: H10K 59/12, H10K 59/131

(54) **DISPLAY PANEL AND DISPLAY APPARATUS**

(30) Priority: 22.12.2023 CN 202311786394
(71) Applicant: Boe Technology Group Co., Ltd., Beijing 100015 (CN); Beijing BOE Technology Development Co., Ltd., Daxing District Beijing 100176 (CN)
(72) Inventor: LV, Guangshuang, Beijing 100176 (CN); XU, Pan, Beijing 100176 (CN); HAN, Ying, Beijing 100176 (CN); ZHANG, Xing, Beijing 100176 (CN); LUO, Chengyuan, Beijing 100176 (CN); ZHAO, Donghui, Beijing 100176 (CN); ZHANG, Dacheng, Beijing 100176 (CN); ZHOU, Dandan, Beijing 100176 (CN)
(74) Representative: Potter Clarkson
(86) International application number: PCT/CN2024/140339
(87) International publication number: WO 2025/130930

(57) **Abstract**

A display panel (PNL) and a display apparatus, which relate to the technical field of display. The display panel (PNL) comprises a base substrate (SBT), a driving layer (DRL) and a pixel layer (PIXL), which are sequentially stacked, wherein the driving layer (DRL) has transistors (TFTs) for driving sub-pixels (PIX); at least one transistor (TFT) comprises a channel region (CR) located on a semiconductor layer (SCL), and comprises two conductive structures (CSs) located on two sides of the channel region (CR); at least one conductive structure (CS) comprises an electrical contact structure (ECS) located on the semiconductor layer (SCL), an overlapping insulation structure (GIS) located on a gate insulation layer (GI), and an overlapping structure (OS) located on a second metal layer (GT); the overlapping insulation structure (GIS) has an overlapping via hole (GIH), and the overlapping structure (OS) is electrically connected to the electrical contact structure (ECS) by means of the overlapping via hole (GIH); and the length direction (ED) of at least one overlapping via hole (GIH) of the at least one transistor (TFT) is not parallel to the length direction (LE) of the channel region (CR) of the transistor (TFT). The display panel (PNL) can improve the space utilization rate to the greatest extent, improve the aperture ratio of a display device, and prolong the service life of an OLED device.

## Description

### CROSS-REFERENCE TO RELATED APPLICATION

The present disclosure claims priority to Chinese Patent Application No. 202311786394.3, filed on December 22, 2023, titled "DISPLAY PANEL AND DISPLAY APPARATUS", which is incorporated herein by reference in its entirety.

### TECHNICAL FIELD

The present disclosure relates to the field of display technologies, and in particular, to a display panel and a display apparatus.

### BACKGROUND

With the continuous development of display technologies, the application of display panels is becoming more and more extensive, and people's requirements for display panels are also becoming higher and higher. Images displayed by display panels with the high number of pixels per inch have high density and good picture quality. However, the higher the number of pixels per inch in a display panel, the smaller the pixel size and the smaller the layout space. For a display panel with the high number of pixels per inch and bottom-emission organic light-emitting diode (OLED) devices, a reasonable layout is required to maximize space utilization, increase the aperture ratio, and increase the lifetime of the OLED devices.

### SUMMARY

The purpose of the present disclosure is to overcome the above-mentioned deficiencies of the prior art, and then provide a display panel and a display apparatus to increase the number of pixels per inch and the aperture ratio.

In a first aspect of the present disclosure, a display panel is provided. The display panel includes a base substrate, a driving layer and a pixel layer that are stacked in sequence; the driving layer has transistors for driving sub-pixels, and the driving layer includes a first metal layer, a semiconductor layer, a gate insulating layer, a second metal layer and a planarization layer that are stacked in sequence on the base substrate;
at least one of the transistors includes a channel region located in the semiconductor layer, and two conductive structures located on both sides of the channel region; at least one of the conductive structures includes an electrical contact structure located in the semiconductor layer, an overlapping insulation structure located in the gate insulating layer, and an overlapping structure located in the second metal layer;
the overlapping insulation structure has an overlapping via hole, and the overlapping structure is electrically connected to the electrical contact structure through the overlapping via hole; and
a length direction of at least one overlapping via hole of the at least one transistor is non-parallel to a length direction of a channel region of the transistor.

In an embodiment of the present disclosure, a length direction of one overlapping via hole of the at least one transistor is perpendicular to the length direction of the channel region of the transistor.

In an embodiment of the present disclosure, length directions of two overlapping via holes of the at least one transistor are both perpendicular to the length direction of the channel region of the transistor.

In an embodiment of the present disclosure, the overlapping via hole extends to an edge of the overlapping insulation structure and is in an opening structure, and a length direction of the overlapping via hole is an opening direction of the overlapping via hole.

In an embodiment of the present disclosure, an orthographic projection of the gate insulating layer on the base substrate does not exceed an orthographic projection of the second metal layer on the base substrate.

In an embodiment of the present disclosure, at least one of electrical contact structures has an adjacent region that is exposed by the gate insulating layer and the second metal layer and is adjacent to an overlapping via hole, and a thickness of the semiconductor layer in the adjacent region is less than a thickness of the semiconductor layer in the channel region.

In an embodiment of the present disclosure, in a length direction of the overlapping via hole, a size of the adjacent region is less than a size of the overlapping via hole.

In an embodiment of the present disclosure, the electrical contact structure includes a first conductive region, a second conductive region and a third conductive region that are connected in sequence; and
the first conductive region is located between the channel region of the transistor and the adjacent region, the second conductive region is located on a side of the adjacent region away from the overlapping via hole, and the third conductive region is located on a side of the adjacent region away from the channel region.

In an embodiment of the present disclosure, the driving layer further includes a first metal layer and an inorganic buffer layer located between the base substrate and the semiconductor layer; the inorganic buffer layer is located between the first metal layer and the semiconductor layer; and the first metal layer and the second metal layer are connected through via holes.

In an embodiment of the present disclosure, at least one of overlapping via holes further includes a first auxiliary hole covered by the overlapping structure and extending beyond the electrical contact structure; the inorganic buffer layer has a second auxiliary hole aligned with the first auxiliary hole, and the first auxiliary hole and the second auxiliary hole expose at least a portion of the first metal layer; and
the overlapping structure is electrically connected to the first metal layer through the first auxiliary hole and the second auxiliary hole.

In an embodiment of the present disclosure, the driving layer has pixel driving circuits for driving the pixel layer; a pixel driving circuit includes a storage capacitor, a first transistor, a second transistor, and a third transistor, and the transistors each include a gate, a first electrode, and a second electrode;
a first electrode of the first transistor is used for loading a driving power supply voltage, a gate of the first transistor is electrically connected to a second electrode of the second transistor and a first electrode plate of the storage capacitor, and a second electrode of the first transistor is electrically connected to a second electrode of the third transistor, a pixel electrode of a sub-pixel and a second electrode plate of the storage capacitor; a first electrode of the third transistor is electrically connected to a sensing signal line; and a first electrode of the second transistor is used for loading a data voltage;
a gate of the second transistor and a gate of the third transistor are used for loading a scan signal;
the inorganic buffer layer and the gate insulating layer have a sensing via hole, and the sensing signal line is electrically connected to the second metal layer through the sensing via hole; and
the first transistor has a first conductive structure adjacent to the sensing via hole, and a length direction of an overlapping via hole of the first conductive structure is perpendicular to a channel region of the first transistor.

In an embodiment of the present disclosure, the length direction of the overlapping via hole of the first conductive structure is a row direction; and
a length direction of the channel region of the first transistor is a column direction.

In an embodiment of the present disclosure, the driving layer has pixel driving circuits for driving the pixel layer; a pixel driving circuit includes a storage capacitor, a first transistor, a second transistor, and a third transistor, and the transistors each include a gate, a first electrode, and a second electrode;
a first electrode of the first transistor is used for loading a driving power supply voltage, a gate of the first transistor is electrically connected to a second electrode of the second transistor and a first electrode plate of the storage capacitor, and a second electrode of the first transistor is electrically connected to a second electrode of the third transistor, a pixel electrode of a sub-pixel and a second electrode plate of the storage capacitor; a first electrode of the third transistor is electrically connected to a sensing signal line; and a first electrode of the second transistor is used for loading a data voltage;
a gate of the second transistor and a gate of the third transistor are used for loading a scan signal;
the inorganic buffer layer and the gate insulating layer have a sensing via hole, and the sensing signal line is electrically connected to the second metal layer through the sensing via hole; and
the third transistor has a second conductive structure adjacent to the sensing via hole, and a length direction of an overlapping via hole of the second conductive structure is perpendicular to a channel region of the third transistor.

In an embodiment of the present disclosure, length directions of overlapping via holes of the two conductive structures in the third transistor are both a column direction; and
a length direction of the channel region of the third transistor is a row direction.

In a second aspect of the present disclosure, a display apparatus is provided. The display apparatus includes the display panel described above.

The display panel disclosed herein may maximize space utilization, increase the aperture ratio of the display device, and increase the lifetime of the OLED device.

It should be understood that the foregoing general description and the following detailed description are exemplary and explanatory only and are not limitations on the present disclosure.

### BRIEF DESCRIPTION OF THE DRAWINGS

The accompanying drawings, which are incorporated into the specification and constitute a part of the specification, illustrate embodiments in accordance with the present disclosure, and are used together with the specification to explain the principle of the present disclosure. Obviously, the accompanying drawings to be described below are merely drawings of some embodiments of the present disclosure, and a person of ordinary skilled in the art can obtain other drawings according to these drawings without paying any creative effort.
FIG. 1 is a schematic diagram showing a planar structure of a display panel, in accordance with an embodiment of the present disclosure.
FIG. 2 is a schematic diagram showing a film-layer structure of a display panel, in accordance with an embodiment of the present disclosure.
FIG. 3 is an equivalent circuit diagram of a pixel driving circuit of 3T1C, in accordance with an embodiment of the present disclosure.
FIG. 4 is a schematic structural diagram of a first conductive structure, in accordance with an embodiment of the present disclosure.
FIG. 5 is a schematic structural diagram of an overlapping insulation structure of a first conductive structure, in accordance with an embodiment of the present disclosure.
FIG. 6 is a partial sectional schematic diagram of a first conductive structure, in accordance with an embodiment of the present disclosure.
FIG. 7 is a schematic structural diagram of a second conductive structure, in accordance with an embodiment of the present disclosure.
FIG. 8 is a schematic structural diagram of an overlapping insulation structure of a second conductive structure, in accordance with an embodiment of the present disclosure.
FIG. 9 is a partial sectional schematic diagram of a second conductive structure, in accordance with an embodiment of the present disclosure.
FIG. 10 is a schematic structural diagram of a third conductive structure, in accordance with an embodiment of the present disclosure.
FIG. 11 is a schematic structural diagram showing an overlapping via hole formed in a gate insulating layer, in accordance with an embodiment of the present disclosure.
FIG. 12 is a schematic structural diagram of forming a second metal layer by a photolithography process, in accordance with an embodiment of the present disclosure.
FIG. 13 is a schematic structural diagram of patterning a gate insulating layer by using a second metal layer as a mask, in accordance with an embodiment of the present disclosure.
FIG. 14 is a schematic diagram showing a conductive channel of a first conductive structure, in accordance with an embodiment of the present disclosure.
FIG. 15 is a schematic diagram showing a conductive channel of a second conductive structure, in accordance with an embodiment of the present disclosure.
FIG. 16 is a schematic diagram showing via hole connections of an I-type transistor, in accordance with an embodiment of the present disclosure.
FIG. 17 is a schematic diagram showing via hole connections of an L-type transistor, in accordance with an embodiment of the present disclosure.
FIG. 18 is a schematic diagram showing a film-layer structure of a display panel, in accordance with an embodiment of the present disclosure.
FIG. 19 is a schematic diagram showing partial structures of a first metal layer, a second metal layer and a semiconductor layer in FIG. 18.
FIG. 20 is a schematic diagram showing partial structures of a first metal layer, a second metal layer and a semiconductor layer in a case where an I-type transistor is adopted, in accordance with an embodiment of the present disclosure.
FIG. 21 is a schematic diagram showing via hole connections of a single-sided L-type transistor, in accordance with an embodiment of the present disclosure.
FIG. 22 is a schematic diagram showing partial structures of a first metal layer, a second metal layer and a semiconductor layer in a case where a single-sided L-type transistor is adopted, in accordance with an embodiment of the present disclosure.
FIG. 23 is a schematic diagram showing via hole connections of a double-sided L-type transistor, in accordance with an embodiment of the present disclosure.
FIG. 24 is a schematic diagram showing partial structures of a first metal layer, a second metal layer and a semiconductor layer in a case where a double-sided L-type transistor is adopted, in accordance with an embodiment of the present disclosure.
FIG. 25 is a schematic diagram showing offset via hole connections of an L-type transistor, in accordance with an embodiment of the present disclosure.
FIG. 26 is a schematic diagram showing via hole connections of an L-type transistor with a compensation region, in accordance with an embodiment of the present disclosure.
FIG. 27 is a schematic diagram showing partial structures of a first metal layer, a second metal layer and a semiconductor layer in a case where an L-type transistor with a compensation region is adopted, in accordance with an embodiment of the present disclosure.

### DESCRIPTION OF REFERENCE NUMERALS

AA, display region; AB, adjacent region; AH1, first auxiliary hole; AH2, second auxiliary hole; BB, peripheral region; BUF, inorganic buffer layer; COML, common electrode layer; CR, channel region; CS, conductive structure; CST, storage capacitor; CST1, first electrode plate of storage capacitor; CST2, second electrode plate of storage capacitor; CZ, compensation region; DH, row direction; DL, data signal line; DRL, driving layer; DV, column direction; ECS, electrical contact structure; ECS1, first conductive region; ECS2, second conductive region; ECS3, third conductive region; ED, length direction; EFL, light-emitting functional layer; GL, scan signal line; GI, gate insulating layer; GIS, overlapping insulation structure; GIH, overlapping via hole; GIV, sensing via hole; GS, scan signal; GT, second metal layer; ITO1, transparent conductive layer; LE, length direction; OE, opening edge; OS, overlapping structure; PDC, pixel driving circuit; PDL, pixel definition layer; PEL, pixel electrode layer; PE, pixel electrode; PIXL, pixel layer; PIX, sub-pixel; PLN, planarization layer; PNL, display panel; PVX, passivation layer; PR, photoresist layer; SBT, base substrate; SCL, semiconductor layer; SHL, first metal layer; SL, sensing signal line; T1, first transistor; T1CR, channel region of first transistor; T2, second transistor; T3, third transistor; T3CR, channel region of third transistor; TFT, transistor; VDD, driving power supply voltage; VDDL, driving power supply voltage signal line; VSS, reference power supply voltage; UU, display unit.

### DETAILED DESCRIPTION

Exemplary embodiments will be described more comprehensively with reference to the accompanying drawings. However, the exemplary embodiments can be implemented in various forms, and should not be construed as being limited to the implementations set forth herein. The provision of these embodiments makes the present disclosure more comprehensive and complete, and comprehensively conveys the concept of the exemplary embodiments to those skilled in the art. The same reference numerals in the accompanying drawings denote the same or similar structures, and thus their detailed descriptions will be omitted. In addition, the accompanying drawings are merely schematic illustrations of the present disclosure and are not necessarily drawn to scale.

Although relative terms such as "upper" and "lower" are used in the specification to describe a relative relationship of a component to another component in the drawing, these terms are used in the specification only for convenience, for example, based on directions of examples in the drawings. It can be understood that if the apparatus in the drawing is turned upside down, the component on an "upper" side will become the component on a "lower" side. In a case where a structure is "on" another structure, it may mean that the structure is integrally formed on the another structure, or that the structure is "directly" provided on the another structure, or that the structure is "indirectly" provided on the another structure through yet another structure.

The terms "a", "an", "the", and "at least one" are used to indicate the presence of one or more elements/components. The terms "comprising" and "having" are used to indicate an open inclusion and mean that there may be additional elements/components in addition to the listed elements/components. The terms "first", "second", "third", etc. are used only as labels and are not intended to limit the quantity of the objects.

In the embodiments of the present disclosure, the transistor has an active layer. The active layer is located in a semiconductor layer and includes a channel region, and a source and a drain located on both sides of the channel region. The channel region maintains semiconductor characteristics, and the source and drain are partially or fully conductive. In the embodiments of the present disclosure, in a case where transistors with opposite polarities are used or a direction of the current in the circuit during operation changes, functions of the "source" and "drain" are sometimes interchanged. That is, the "source" and "drain" can be interchanged. In the embodiments of the present disclosure, for any transistor, one of a "first electrode" and a "second electrode" is referred to as the source of the transistor, and the other of the "first electrode" and the "second electrode" is referred to as the drain of the transistor.

In the embodiments of the present disclosure, the channel region of the transistor has a length direction and a width direction. The length direction of the channel region of the transistor refers to a direction in which the current mainly flows, and the width direction of the channel region of the transistor is perpendicular to the direction in which the current flows. In the length direction of the channel region of the transistor, the active layer of the transistor includes a first electrode, the channel region and a second electrode of the transistor that are in sequence.

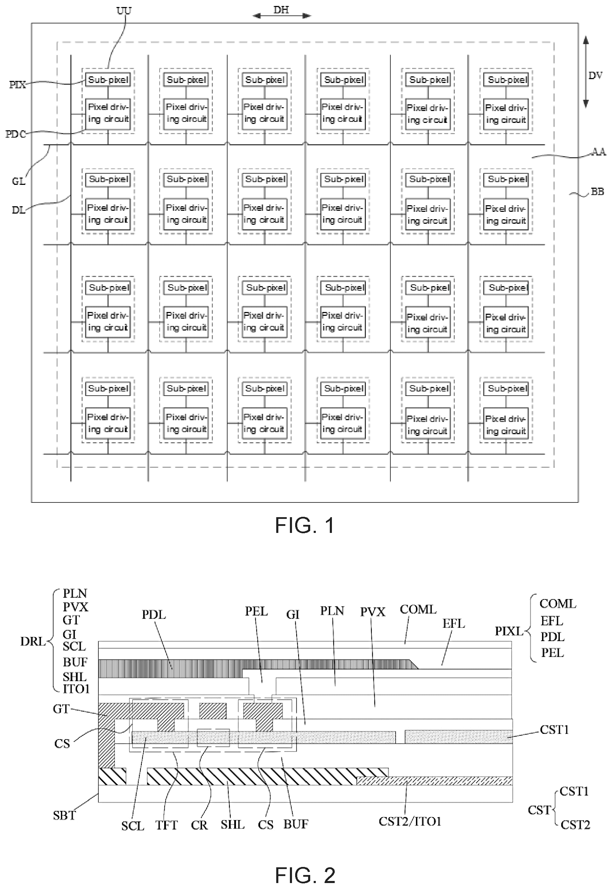

Embodiments of the present disclosure provide a display panel PNL. Referring to FIG. 1, the display panel PNL includes a display region AA and a peripheral region BB located on at least one side of the display region AA. For example, the peripheral region BB surrounds the display region AA. The display region AA of the display panel PNL is provided therein with display units UU distributed in an array. The display unit UU includes a sub-pixel PIX and a pixel driving circuit PDC for driving the sub-pixel PIX. The peripheral region BB of the display panel PNL is not provided therein with display units UU. In other words, the display units UU are not used for displaying images. Referring to FIG. 1, a plurality of scan signal lines GL extending in a row direction DH are provided in the display region AA of the display panel PNL, and the scan signal lines GL are in one-to-one correspondence with rows of display units. The pixel driving circuits PDC of display units UU in a row of display units are all electrically connected to a corresponding scan signal line GL. A plurality of data signal lines DL extending in a column direction DV are provided in the display region AA of the display panel PNL, and the data signal lines DL are in one-to-one correspondence with columns of display units. The pixel driving circuits PDC of display units UU in a column of display units are all electrically connected to a corresponding data signal line DL. Thus, the pixel driving circuit PDC of each display unit UU is connected to a scan signal line GL and a data signal line DL. When a scan signal is loaded onto the scan signal line GL, a driving voltage loaded on the data signal line DL can be written into the pixel driving circuit PDC, so that the pixel driving circuit PDC can control the brightness of the sub-pixel PIX according to the written driving voltage.

Optionally, the pixel driving circuit PDC includes at least a data writing transistor, a driving transistor and a storage capacitor CST, and a gate of the driving transistor can be electrically connected to one electrode plate of the storage capacitor CST. A source of the data writing transistor can be electrically connected to the data signal line DL, and a gate of the data writing transistor can be electrically connected to the scan signal line GL. The pixel driving circuit PDC is configured such that when a scan signal GS is loaded onto the scan signal line GL, the data writing transistor is turned on to enable the driving voltage on the data signal line DL to be written into the gate of the driving transistor and the storage capacitor CST. When the data writing transistor is turned off, the driving voltage can be maintained by the storage capacitor CST. The driving transistor can output a driving current under the control of the voltage at the gate of the driving transistor, so as to drive the sub-pixel PIX to emit light. It can be understood that the pixel driving circuit PDC in the embodiments of the present disclosure may further include other transistor(s) or capacitor(s), and thus the pixel driving circuit PDC has better driving performance. For example, the pixel driving circuit PDC may be a pixel driving circuit PDC of 7T1C (which has seven transistors TFT and one storage capacitor CST), a pixel driving circuit PDC of 8T1C (which has eight transistors TFT and one storage capacitor CST), or a pixel driving circuit PDC of another architecture.

In the embodiments of the present disclosure, the sub-pixels PIX in the display panel PNL are current-driven self-luminous elements, e.g., thin-film self-luminous elements. For example, the sub-pixel PIX is an OLED, a polymer light-emitting diode (PLED), a quantum dot light-emitting diode (QLED), or the like. Furthermore, the sub-pixels PIX located in the display region AA include sub-pixels PIX of multiple different colors. For example, the sub-pixels PIX include red sub-pixels for emitting red light, green sub-pixels for emitting green light, and blue sub-pixels for emitting blue light. It can be understood that, in other embodiments of the present disclosure, the sub-pixels PIX in the display region AA may be sub-pixels PIX of only one color, or may include sub-pixels PIX of other colors (for example, yellow sub-pixels for emitting yellow light, cyan sub-pixels for emitting cyan light, white sub-pixels for emitting white light, etc.).

In an embodiment of the present disclosure, referring to FIG. 2, the display panel PNL can include a base substrate SBT, a driving layer DRL and a pixel layer PIXL that are stacked in sequence. The sub-pixels PIX are arranged in the pixel layer PIXL, and the pixel driving circuits PDC for driving the sub-pixels PIX are arranged in the driving layer DRL. The sub-pixels PIX can emit light under driving of the pixel driving circuits PDC, so as to display images.

Optionally, the base substrate SBT can be a base substrate of an inorganic material or a base substrate of an organic material. Of course, the base substrate SBT can also be a composite substrate formed by stacking a base substrate of an inorganic material and a base substrate of an organic material. For example, in some embodiments of the present disclosure, a material of the base substrate SBT may be a glass material, such as soda-lime glass, quartz glass, or sapphire glass. In some other embodiments of the present disclosure, the material of the base substrate SBT may be polymethyl methacrylate, polyvinyl alcohol, polyvinyl phenol, polyether sulfone, polyimide, polyamide, polyacetal, polycarbonate, polyethylene terephthalate, polyethylene naphthalate, or a combination thereof. In some other embodiments of the present disclosure, the base substrate SBT may be a flexible substrate. For example, the material of the base substrate SBT may include polyimide.

Optionally, in the driving layer DRL, any one of the pixel driving circuits PDC can include transistors TFT and storage capacitor(s) CST. Furthermore, the transistor TFT may be selected from a top-gate transistor, a bottom-gate transistor, or a dual-gate transistor. A material of an active layer of the transistor TFT may be an amorphous silicon semiconductor material, a low-temperature polycrystalline silicon semiconductor material, a metal oxide semiconductor material, an organic semiconductor material, a carbon nanotube semiconductor material, or a semiconductor material of another type. The transistor TFT may be an N-type transistor or a P-type transistor.

In an example, the transistors in the driving layer DRL are top-gate transistors.

In an example, the transistors in the driving layer DRL are metal oxide transistors.

As an example, referring to FIG. 2, the driving layer DRL includes a first metal layer SHL, an inorganic buffer layer BUF, a semiconductor layer SCL, a gate insulating layer GI, a second metal layer GT and a planarization layer PLN that are stacked in sequence. In this way, the transistors TFT formed are top-gate transistors.

In this embodiment, at least a portion of the first metal layer SHL may serve as a light-shielding structure. The light-shielding structure shields a channel region CR of the transistor, which prevents light from irradiating the channel region CR of the transistor from the side where the base substrate is located and avoids causing changes in transistor characteristics. For example, an orthographic projection of the channel region CR of the transistor on the base substrate SBT is located within an orthographic projection of first metal layer SHL on the base substrate SBT.

Furthermore, referring to FIG. 2, the first metal layer SHL is connected to the second metal layer GT through via holes.

Furthermore, referring to FIG. 2, the driving layer DRL further includes a passivation layer PVX located on a side of the second metal layer GT away from the base substrate SBT, and the planarization layer PLN is located on a side of the passivation layer PVX away from the base substrate SBT.

In an embodiment of the present disclosure, referring to FIG. 2, the driving layer DRL further includes a transparent conductive layer ITO1, which is used to form an electrode plate of the storage capacitor CST (for example, a second electrode plate CST2 of the storage capacitor). The semiconductor layer SCL is used to form another electrode plate of the storage capacitor CST (for example, a first electrode plate CST1 of the storage capacitor). Thus, the storage capacitor CST is a transparent storage capacitor. Moreover, the light emitted by the sub-pixel PIX may pass through the transparent storage capacitor, so that the display panel PNL may be a bottom-emission display panel PNL. Furthermore, the transparent conductive layer ITO1 is located between the first metal layer SHL and the base substrate SBT. Specifically, during the fabrication of the display panel PNL, the transparent conductive layer ITO1 is formed first, and then the first metal layer SHL is formed.

Optionally, the transparent conductive layer ITO1 can be made of a transparent conductive metal oxide, such as indium tin oxide.

Optionally, the first metal layer SHL can be made of metal. For example, the first metal layer SHL includes one metal layer or multiple metal layers that are stacked.

Optionally, in a case where the transparent conductive layer ITO1 is electrically connected to the first metal layer SHL, a portion of the first metal layer SHL is overlapped with and directly on the transparent conductive layer ITO1.

In an example of FIG. 2, the sub-pixels PIX in the pixel layer PIXL are thin-film light-emitting elements. The pixel layer PIXL can include a pixel electrode layer PEL, a light-emitting function layer EFL, and a common electrode layer COML that are stacked in sequence. The pixel electrode layer PEL has a plurality of pixel electrodes PE in the display region of the display panel, and the pixel electrodes PE are electrically connected to the pixel driving circuits PDC through via holes.

Furthermore, the pixel layer PIXL can further include a pixel definition layer PDL located between the pixel electrode layer PEL and the light-emitting function layer EFL. The pixel definition layer PDL has a plurality of pixel openings that penetrate through the pixel definition layer PDL and are in one-to-one correspondence with the plurality of pixel electrodes PE, and any one of the pixel openings exposes at least a portion of the corresponding pixel electrode PE.

In an example, the pixel electrode serves as an anode of the sub-pixel PIX, and the common electrode layer COML serves as a cathode of the sub-pixel PIX.

Optionally, the common electrode layer COML is a reflective electrode rather than a transparent electrode. For example, the common electrode layer COML is a metal electrode or a metal oxide electrode. The pixel electrode PE is a transparent electrode. For example, the pixel electrode PE is made of a transparent conductive metal oxide (such as indium tin oxide). Thus, the sub-pixel PIX is a bottom-emission sub-pixel.

In an example, the common electrode layer COML is a metal electrode layer, such as a silver metal layer, an aluminum metal layer, a titanium metal layer, or another metal layer with high reflectivity. Of course, when necessary, a surface of the metal electrode layer may also be modified with an alloy, metal oxide, metal nitride or other materials to adjust the carrier injection characteristics (e.g., electron injection characteristics) of the metal electrode layer. For example, the common electrode layer COML is made of aluminum and has a thickness of 100 nanometers.

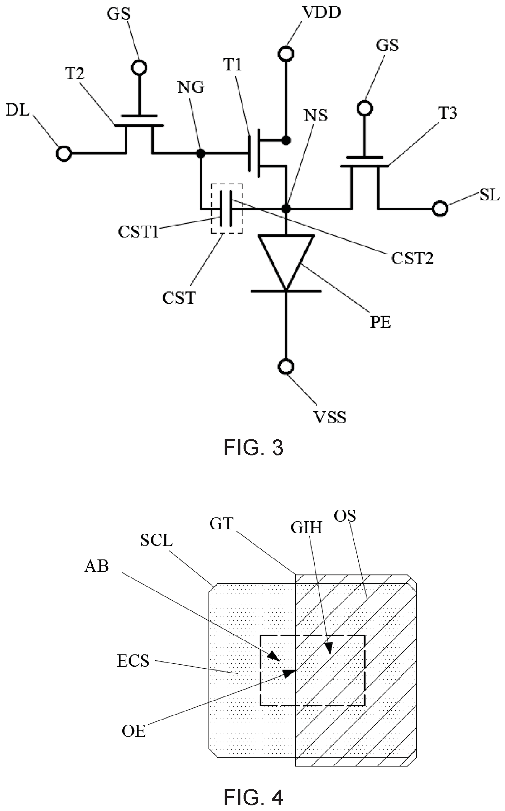

In an embodiment of the present disclosure, referring to FIG. 3, the pixel driving circuit PDC in the driver layer DRL is a circuit of 3T1C, which includes a first transistor T1, a second transistor T2, a third transistor T3 and a storage capacitor CST. A first electrode of the first transistor T1 is electrically connected to a driving power supply voltage signal line VDDL for loading a driving power supply voltage VDD, a gate of the first transistor T1 is electrically connected to a second electrode of the second transistor T2 and the first electrode plate CST1 of the storage capacitor, and a second electrode of the first transistor T1 is electrically connected to a second electrode of the third transistor T3, the pixel electrode PE of the sub-pixel PIX and the second electrode plate CST2 of the storage capacitor. A first electrode of the third transistor T3 is electrically connected to a sensing signal line SL for loading a reference power supply voltage VSS. A first electrode of the second transistor T2 is electrically connected to a data signal line DL for loading a data voltage. A gate of the second transistor T2 and a gate of the third transistor T3 are used for loading a scan signal GS.

Optionally, the driving power supply voltage signal line VDDL is arranged in the first metal layer SHL. Optionally, the driving power supply voltage signal line VDDL extends in the column direction DV.

Optionally, the data signal line DL is arranged in the first metal layer SHL. Optionally, the data signal line DL extends in the column direction DV.

In an example, the gate of the second transistor T2 and the gate of the third transistor T3 are both electrically connected to a scan signal line GL for loading the scan signal GS. In this way, the number of scan signal lines may be reduced, thereby saving layout space and improving the resolution of the display panel PNL.

It can be understood that, in various examples of the present disclosure, the gate of the second transistor T2 and the gate of the third transistor T3 are both connected to the same scan signal line. In other implementations of the present disclosure, in the display panel, two scan signal lines are used to drive the second transistor and the third transistor, respectively. For example, a first scan signal line extending in the row direction and a second scan signal line extending in the row direction are provided in the display panel; the first scan signal line is used to load a first scan signal, and the second scan signal line is used to load a second scan signal. The gate of the second transistor is electrically connected to the first scan signal line, and the gate of the third transistor is electrically connected to the second scan signal line.

Optionally, the scan signal line GL is located in the second metal layer GT. Optionally, the scan signal line GL extends in the row direction DH. In addition, the second metal layer GT further includes the gate of each transistor.

In an example, the sensing signal line SL is located in the first metal layer SHL, and the sensing signal line SL is configured to provide the sensing signal for the pixel driving circuit PDC. Optionally, the sensing signal line SL extends in the column direction DV.

In an example, the second electrode plate CST2 of the storage capacitor is located in the transparent conductive layer ITO1.

In an example, the first electrode plate CST1 of the storage capacitor is located in the semiconductor layer SCL.

In the embodiments of the present disclosure, referring to FIG. 2, at least one of the transistors TFT includes a channel region CR located in the semiconductor layer SCL, and two conductive structures CS located on both sides of the channel region CR. It can be understood that the transistor TFT further includes the gate located in the second metal layer GT, and a gate insulating structure (located in the gate insulating layer GI) between the gate and the channel region CR.

In the embodiments of the present disclosure, the conductive structure CS of the transistor TFT can be selected as needed from any one of three types: a first conductive structure, a second conductive structure, and a third conductive structure. The two conductive structures CS of the transistor TFT may be of the same type or of different types.

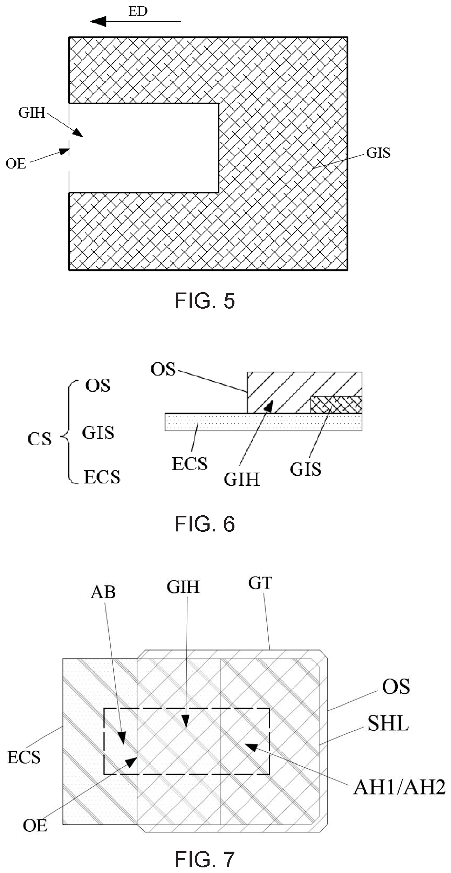

FIG. 4 is a schematic structural diagram of a first conductive structure, FIG. 5 is a schematic structural diagram of an overlapping insulation structure GIS of the first conductive structure, and FIG. 6 is a partial sectional schematic diagram of the first conductive structure.

Referring to FIGS. 4 to 6, the first conductive structure includes an electrical contact structure ECS located in the semiconductor layer SCL, an overlapping insulation structure GIS located in the gate insulating layer GI, and an overlapping structure OS located in the second metal layer GT. The overlapping insulation structure GIS has an overlapping via hole GIH, and the overlapping structure OS is electrically connected to the electrical contact structure ECS through the overlapping via hole GIH. In the first conductive structure, the electrical contact structure ECS and the channel region CR are both located in the semiconductor layer SCL and are arranged adjacent to each other. The electrical contact structure ECS and the channel region CR together serve as a part of the active layer of the transistor TFT. The electrical contact structure ECS can serve as the source or drain of the transistor TFT. The overlapping structure OS is electrically connected to the electrical contact structure ECS through the overlapping via hole GIH, so that the source or drain of the transistor is electrically connected to the second metal layer GT.

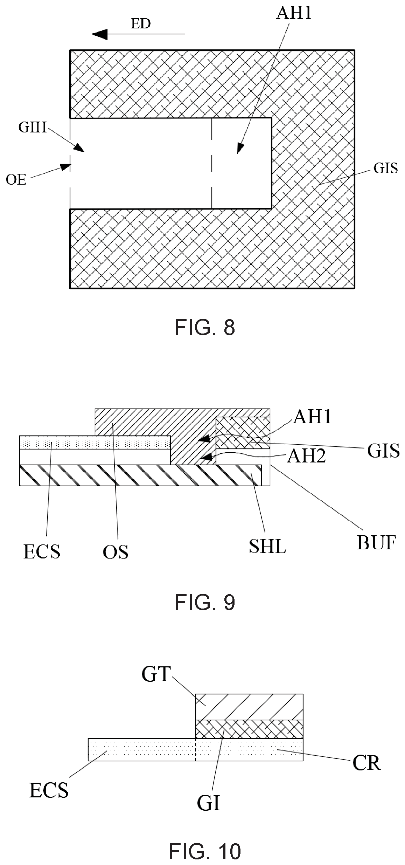

FIG. 7 is a schematic structural diagram of a second conductive structure, FIG. 8 is a schematic structural diagram of an overlapping insulation structure GIS of the second conductive structure, and FIG. 9 is a partial sectional schematic diagram of the second conductive structure.

Referring to FIGS. 7 to 9, the second conductive structure includes an electrical contact structure ECS located in the semiconductor layer SCL, an overlapping insulation structure GIS located in the gate insulating layer GI, and an overlapping structure OS located in the second metal layer GT. Moreover, the second conductive structure overlaps with the inorganic buffer layer BUF and the first metal layer SHL. The overlapping insulation structure GIS has an overlapping via hole GIH, and the overlapping via hole GIH includes a main via hole exposing the semiconductor layer SCL and a first auxiliary hole AH1 that is outside a region where the semiconductor layer SCL is located and capable of exposing the first metal layer SHL. The main via hole and the first auxiliary hole AH1 are adjacent. The inorganic buffer layer BUF has a second auxiliary hole AH2 aligned with the first auxiliary hole AH1, and the first auxiliary hole AH1 and the second auxiliary hole AH2 expose at least a portion of the first metal layer SHL. The overlapping structure OS is electrically connected to the electrical contact structure ECS through the main via hole of the overlapping via hole GIH, and the overlapping structure OS is electrically connected to the first metal layer SHL through the first auxiliary hole AH1 of the overlapping via hole GIH and the second auxiliary hole AH2. In the second conductive structure, the electrical contact structure ECS and the channel region CR are both located in the semiconductor layer SCL and are adjacent to each other. The electrical contact structure ECS and the channel region CR together serve as a part of the active layer of the transistor TFT. The electrical contact structure ECS can serve as the source or drain of the transistor TFT. The overlapping structure OS is electrically connected to the electrical contact structure ECS and the first metal layer SHL through a via hole, so that the source or drain of the transistor is electrically connected to the first metal layer SHL.

FIG. 10 is a schematic structural diagram of a third conductive structure. Referring to FIG. 10, the third conductive structure includes an electrical contact structure ECS located in the semiconductor layer SCL. The electrical contact structure ECS is not electrically connected to the second metal layer GT or the first metal layer SHL through a via hole. The electrical contact structure ECS and the channel region CR are both located in the semiconductor layer SCL and are adjacent to each other. The electrical contact structure ECS and the channel region CR together serve as a part of the active layer of the transistor TFT.

In the embodiments of the present disclosure, at least one of the conductive structures CS is selected from the first conductive structure or the second conductive structure, so that the source or drain of the transistor is electrically connected to another conductive film-layer (e.g., the second metal layer GT or the first metal layer SHL).

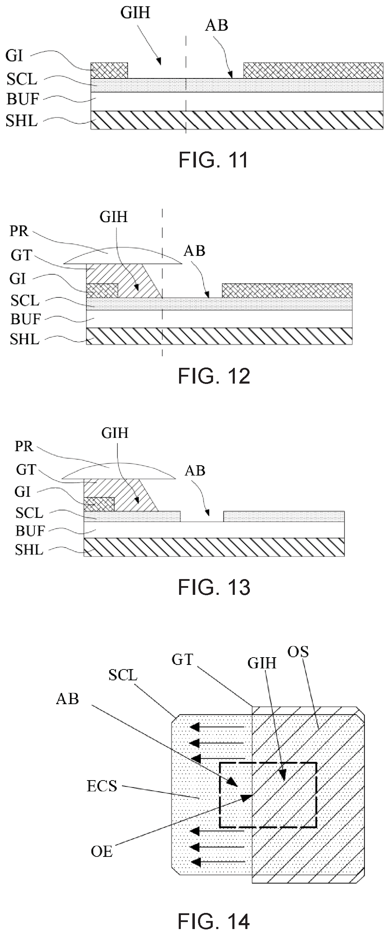

FIGS. 11 to 13 are illustrated by taking the first conductive structure as an example to exemplarily introduce a manufacturing process of some film-layers of the display panel PNL.

Referring to FIG. 11, during manufacturing of the display panel PNL, a patterned semiconductor layer SCL may be manufactured first, and then a gate insulating layer GI may be manufactured. When the gate insulating layer GI is manufactured, a whole-layer gate insulating layer GI may be deposited first, and then via holes may be opened in the whole-layer gate insulating layer GI. In the via hole shown in FIG. 11, the via hole includes an overlapping via hole GIH and an adjacent via hole adjacent to the overlapping via hole GIH. The overlapping via hole GIH and the adjacent via hole are two parts of the whole via hole. The via hole exposes at least a portion of the semiconductor layer SCL, a region of the semiconductor layer SCL exposed by the overlapping via hole GIH is an overlapping region, and a region of the semiconductor layer SCL exposed by the adjacent via hole is an adjacent region AB. After the via hole is formed in the whole-layer gate insulating layer GI, a conductive treatment is performed on the exposed portion of the semiconductor layer SCL by using an ion implantation method, so that the overlapping region and the adjacent region AB of the semiconductor layer SCL are both conductive, and a portion of the semiconductor layer SCL covered by the gate insulating layer GI is not conductive. Referring to FIG. 12, a second metal layer GT is then manufactured. For example, a whole-layer second metal layer GT is formed on a side of the second metal layer GT away from the semiconductor layer SCL, and then the whole-layer second metal layer GT is patterned using a photolithography process. For example, in the example of FIG. 12, the photoresist layer PR serving as a mask still remains on the second metal layer GT. Referring to FIG. 12, when the second metal layer GT is formed, the second metal layer GT covers the overlapping region and exposes the adjacent region AB. In other words, in the via hole formed in the whole-layer gate insulating layer GI, the portion exposing the semiconductor layer SCL and covered by the second metal layer GT is the overlapping via hole GIH, and the portion exposing the semiconductor layer SCL and not covered by the second metal layer GT is the adjacent via hole. Referring to FIG. 13, the gate insulating layer GI having the via hole is patterned using the second metal layer GT as a mask (or using the photoresist layer PR defining the pattern of the second metal layer GT as a mask). For example, the gate insulating layer GI not covered by the mask (i.e., the second metal layer GT or the photoresist layer PR) is removed by etching. This allows the semiconductor layer SCL that does not overlap with the mask to be exposed. Then, the conductive treatment is performed on the exposed portion of the semiconductor layer SCL by using an ion implantation method. During this process, the channel region CR of the transistor is protected by the gate of the transistor, thereby maintaining semiconductor characteristics.

In the first conductive structure, the overlapping structure OS located in the second metal layer GT only partially overlaps the electrical contact structure ECS located in the semiconductor layer SCL. The overlapping region and the adjacent region AB of the electrical contact structure ECS are conductive during the first conductive treatment process, and a portion of the electrical contact structure ECS not covered by the overlapping structure OS is conductive during the second conductive treatment process. Therefore, referring to FIG. 14, the electrical contact structure ECS has a conductive channel that has undergone the conductive treatment, and the conductive channel includes the overlapping region, the adjacent region AB and the remaining portion not covered by the second metal layer GT (as indicated by the arrow). An edge of the overlapping structure OS defines a boundary between the overlapping region and the adjacent region AB, which enables the overlapping region to maintain electrical communication with the remaining conductive channels through the adjacent region AB.

Therefore, referring to FIGS. 5 and 14, the overlapping via hole GIH of the overlapping insulation structure GIS in the first conductive structure extends to an edge of the overlapping insulation structure and is in an opening structure (i.e., the overlapping via hole GIH is a non-closed via hole), and an opening edge OE of the overlapping via hole GIH is flush with at least one edge of the overlapping structure OS. Furthermore, referring to FIG. 13, in the process of patterning the gate insulating layer GI by using the second metal layer GT as a mask, the semiconductor layer SCL in the adjacent region AB may be damaged during the etching process because it is not covered by the gate insulating layer GI. For example, the portion of the semiconductor layer SCL in the adjacent region AB may be thinned or even partially etched through. Therefore, in the first conductive structure CS, it may happen that a thickness of the semiconductor layer SCL in the adjacent region AB is less than a thickness of the semiconductor layer SCL in the channel region CR.

In an example, in at least one of first conductive structures, the thickness of the semiconductor layer SCL in the adjacent region AB is less than the thickness of the semiconductor layer SCL in the channel region CR.

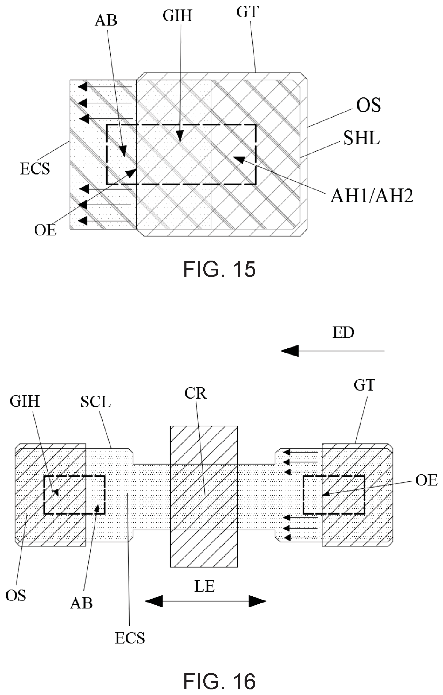

A manufacturing process of the second conductive structure is similar to that of the first conductive structure. During manufacturing of the display panel PNL, a first metal layer SHL and an inorganic buffer layer BUF need to be manufactured before manufacturing the semiconductor layer SCL; when the semiconductor layer SCL is manufactured, the semiconductor layer SCL partially overlaps the first metal layer SHL. For example, the electrical contact structure ECS of the second conductive structure CS partially overlaps the first metal layer SHL that is to be connected. A portion of the first metal layer SHL needs to extend beyond the electrical contact structure ECS, and the portion that is spatially adjacent to but does not overlap with the electrical contact structure ECS can be called an extension of the first metal layer SHL. After a whole-layer gate insulating layer GI is manufactured, via holes are opened. In a region where the second conductive structure is located, the via hole of the gate insulating layer GI includes two parts connected in sequence, namely, an adjacent via hole and an overlapping via hole GIH. Different from the first conductive structure, the overlapping via hole GIH of the second conductive structure includes a main via hole exposing the semiconductor layer SCL and a first auxiliary hole AH1 that is outside a region where the semiconductor layer SCL is located and capable of exposing the first metal layer SHL. Moreover, over-etching may be performed during the process of forming the via hole, so that the inorganic buffer layer BUF is further etched in a region where the first auxiliary hole AH1 is located to form a second auxiliary hole AH2 exposing the extension of the first metal layer SHL. Therefore, in the second conductive structure, the boundary between the main via hole and the first auxiliary hole AH1 of the overlapping via hole GIH is substantially an edge of the electrical contact structure ECS. When the second metal layer GT is formed, the overlapping structure OS of the second conductive structure CS is electrically connected to the electrical contact structure ECS through the main via hole, and is electrically connected to the first metal layer SHL through the first auxiliary hole AH1 and the second auxiliary hole AH2. Similar to the first conductive structure, the overlapping via hole GIH of the second conductive structure is in an opening structure, and the opening edge OE of the overlapping via hole GIH is flush with at least one edge of the overlapping structure OS. Referring to FIG. 15, similar to the first conductive structure, the electrical contact structure ECS of the second conductive structure also has a conductive channel that has undergone the conductive treatment.

In an example, the via hole formed in the gate insulating layer GI before the first conductive treatment is a strip-shaped hole, e.g., a rectangular hole. A length direction of the strip-shaped hole is an opening direction of the overlapping via hole GIH. Furthermore, the overlapping via hole GIH is rectangular, and a length direction of the overlapping via hole GIH is the length direction ED of the overlapping via hole GIH. In this way, the size of the overlapping area may be ensured to reduce the contact resistance, and the existence of the adjacent region AB may be ensured to ensure the stability of the conductive channel.

In an example, since the gate insulating layer GI is patterned using the second metal layer GT as a mask, an orthographic projection of the gate insulating layer GI on the base substrate SBT does not exceed an orthographic projection of the second metal layer GT on the base substrate SBT.

In an example, at least one electrical contact structure ECS has an adjacent region AB that is exposed by the gate insulating layer GI and the second metal layer GT and is adjacent to the overlapping via hole GIH, and a thickness of the semiconductor layer SCL in the adjacent region AB is less than a thickness of the semiconductor layer SCL in the channel region CR. For example, a portion of the electrical contact structure ECS in the adjacent region AB is over-etched and thinned during the etching process of the gate insulating layer, or even partially etched through.

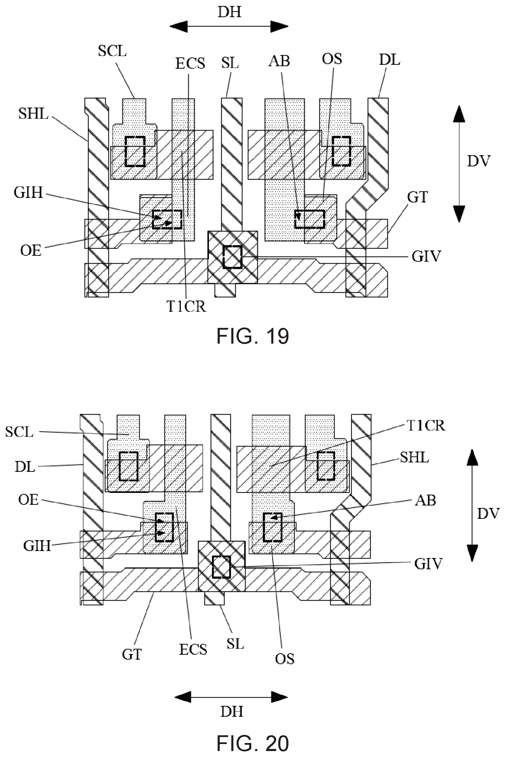

In the related art, referring to FIGS. 16 and 20, the conductive structure CS of the transistor adopts the first conductive structure or the second conductive structure, and the length directions ED of the two overlapping via holes GIH of the transistor TFT are parallel to the length direction LE of the channel region CR. In the embodiments of the present disclosure, such a transistor TFT is referred to as an I-type transistor TFT. The via hole connection manner of the I-type transistor TFT will make the size of the transistor TFT in the length direction LE of the channel region CR too large, which will cause the overlapping structure OS to squeeze the space of other structures located in the second metal layer GT. In order to avoid excessive proximity between different structures in the second metal layer GT, the total space occupied by the second metal layer GT is relatively large, which will compress the pixel opening, resulting in a low aperture ratio or a low resolution.

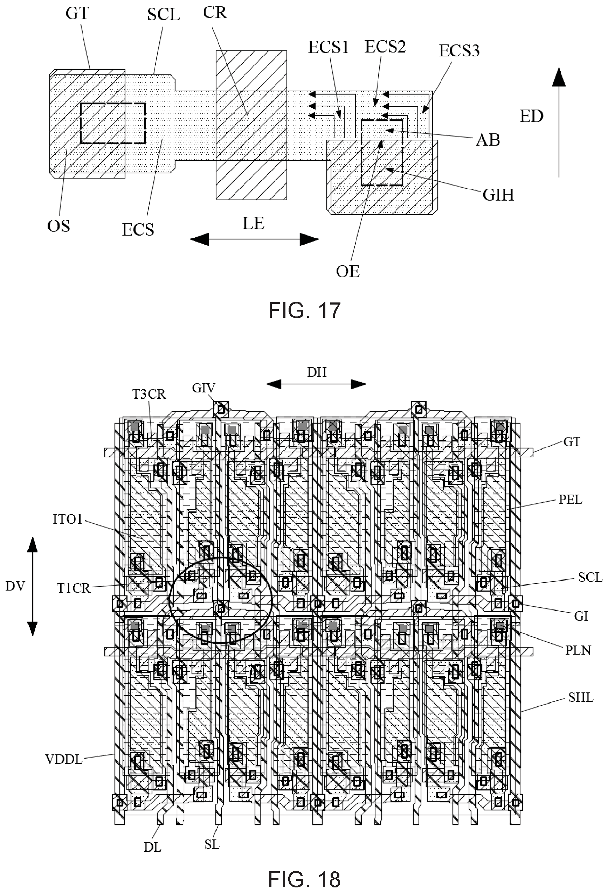

In the embodiments of the present disclosure, referring to FIGS. 17 to 19, at least one transistor TFT is optimized, and in the optimized transistor TFT, the length direction ED of at least one overlapping via hole GIH is non-parallel to the length direction LE of the channel region CR. In an example, the length direction ED of the overlapping via hole GIH is the opening direction of the overlapping via hole GIH, and the opening direction refers to a direction in which the gap of the via hole in the gate insulating layer GI faces. In the embodiments of the present disclosure, if the length direction ED of the overlapping via hole GIH of a conductive structure CS (the first conductive structure or the second conductive structure) is non-parallel to the length direction LE of the channel region CR, then the conductive structure CS is referred to as an L-type conductive structure.

In the embodiments of the present disclosure, in a case where high-PPI bottom-emission OLED devices are laid out, the via hole connection manner in which the length direction ED of the overlapping via hole GIH is non-parallel to the length direction LE of the channel region CR is used. This may save the layout space, and in particular, may reduce the size of the transistor in the length direction LE of the channel region CR, thereby making the layout design of the OLED device more reasonable, improving the utilization of the layout space, and improving the display effect of the OLED device. In other words, the display panel PNL in the embodiments of the present disclosure may improve the space utilization and reduce the layout area of the pixel driving circuit PDC by making at least one transistor TFT of the pixel driving circuit PDC adopt the L-type conductive structure, thereby improving the PPI of the display panel.

The transistor TFT of the display panel PNL provided in the embodiments of the present disclosure will be described in detail below with reference to the accompanying drawings.

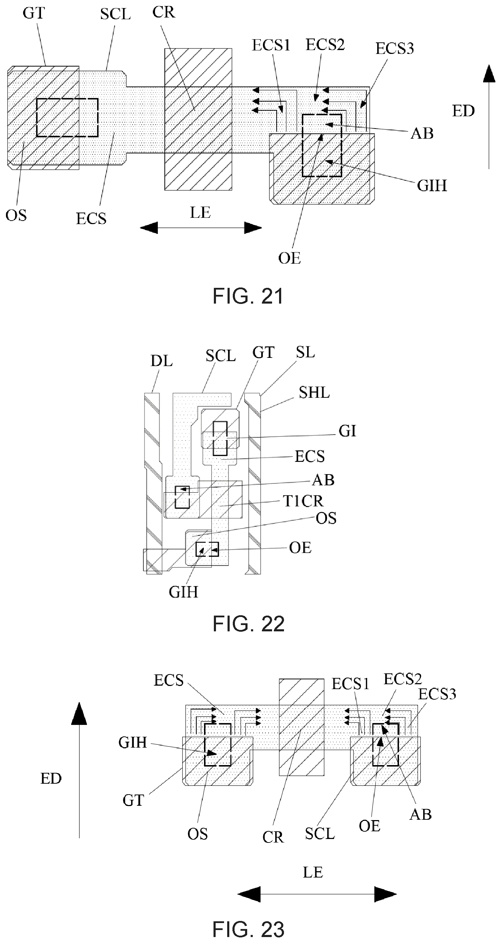

In an embodiment of the present disclosure, referring to FIGS. 21 and 22, the length direction ED of one overlapping via hole GIH in each of at least one transistor TFT is perpendicular to the length direction LE of the channel region CR of the transistor TFT. In this way, only one conductive structure CS in the transistor TFT is the L-type conductive structure, and the transistor is a single-sided L-type transistor TFT, which may increase space utilization. The other conductive structure CS of the transistor TFT can be the third conductive structure, or can be the first conductive structure or the second conductive structure, and the length direction ED of the overlapping via hole GIH of the other conductive structure CS can be parallel to the length direction LE of the channel region CR of the transistor TFT.

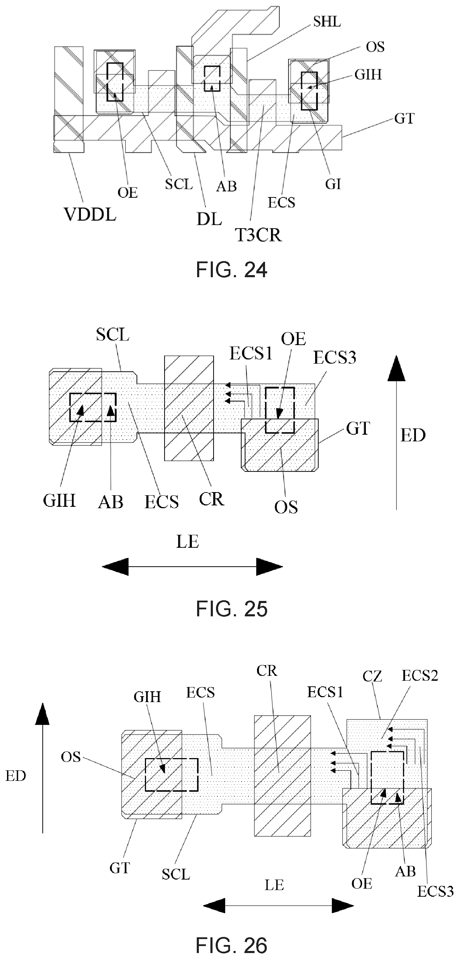

In another embodiment of the present disclosure, referring to FIGS. 23 and 24, the length directions ED of the two overlapping via holes GIH in each of at least one transistor TFT are both perpendicular to the length direction LE of the channel region CR of the transistor TFT. In this way, the two conductive structures CS of the transistor TFT are both L-type conductive structures, and the transistor TFT is a double-sided L-type transistor TFT, which may further save the space, maximize the space utilization, and improve the aperture ratio. Furthermore, the transistor TFT is U-shaped.

In an embodiment of the present disclosure, referring to FIG. 17, the overlapping via hole GIH is rectangular, and the length direction ED of the overlapping via hole GIH is the length direction of the overlapping via hole GIH. In the L-shaped conductive structure, this may reduce the size of the conductive structure CS of the transistor TFT in the length direction LE of the channel region CR and increase the size of the conductive structure CS of the transistor TFT in the width direction of the channel region CR, thereby improving the space utilization.

Optionally, referring to FIG. 17, in the length direction ED of the overlapping via hole GIH, the size of the adjacent region AB is less than that of the overlapping via hole GIH. In this way, the size of the overlapping via hole GIH may be increased, the contact area of the overlapping structure OS and the electrical contact structure ECS may be increased, and the contact resistance may be reduced.

Optionally, referring to FIG. 17, in the L-shaped conductive structure, the electrical contact structure ECS includes a first conductive region ECS1, a second conductive region ECS2, and a third conductive region ECS3 that are connected in sequence. The first conductive region ECS1 is located between the channel region CR of the transistor TFT and the adjacent region AB, the second conductive region ECS2 is located on a side of the adjacent region AB away from the overlapping via hole GIH, and the third conductive region ECS3 is located on a side of the adjacent region AB away from the channel region CR. In this way, the first conductive region ECS1, the second conductive region ECS2 and the third conductive region ECS3 are connected in sequence to form the conductive channel, thereby ensuring smooth signal transmission.

In an example, during the manufacturing of the conductive structure CS, due to the interlayer coverage between the film-layers, the via hole first opened in the gate insulating layer GI may be offset as a whole, and the offset direction is the length direction ED of the overlapping via hole GIH. Referring to FIG. 25, when the via hole offset occurs, the adjacent region AB will compress or even isolate the second conductive region ECS2, and the electrical connectivity between the first conductive region ECS1 and the third conductive region ECS3 will be reduced or even isolated, thereby causing the conductive channel to become small and the impedance to increase, and affecting the characteristics of the transistor TFT.

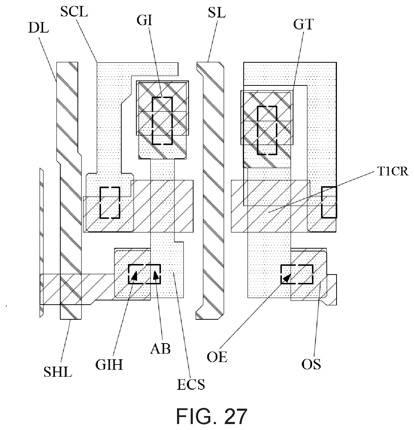

In an example, referring to FIGS. 26 and 27, in the L-shaped conductive structure, the electrical contact structure ECS can further include a compensation region CZ, and the compensation region CZ is located on a side of the adjacent region AB away from the overlapping via hole GIH and extends toward the side away from the overlapping via hole GIH, so as to increase the second conductive region ECS2. For example, referring to FIG. 26, in the length direction ED of the overlapping via hole GIH, a distance between an outer edge of the compensation region CZ and the edge of the overlapping structure OS is greater than a distance between an outer edge of the first conductive region ECS1 and the edge of the overlapping structure OS. The outer edge of the compensation region CZ refers to an edge of the compensation region CZ that is farthest from the edge of the overlapping structure OS among the edges of the compensation region CZ. The outer edge of the first conductive region ECS1 refers to an edge of the first conductive region ECS1 that is farthest from the edge of the overlapping structure OS among the edges of the first conductive region ECS1. In this way, the conductive channel may be enlarged, and poor contact caused by via hole offset due to the interlayer coverage between film-layers may be avoided.

In a case where the L-shaped conductive structure shown in FIG. 26 is a schematic structural diagram of the L-shaped conductive structure when the via hole first opened in the gate insulating layer GI is offset, referring to FIG. 26, by arranging the compensation region CZ, even if the via hole first opened in the gate insulating layer GI is offset, the second conductive region ECS2 may not be completely isolated. In the L-shaped conductive structure shown in FIG. 27, the via hole first opened in the gate insulating layer GI is not offset. Referring to FIG. 27, by arranging the compensation region CZ, the width of the second conductive region ECS2 may be increased, thereby improving the process window of the second conductive region ECS2.

In an embodiment of the present disclosure, referring to FIGS. 3 and 19, the inorganic buffer layer BUF and the gate insulating layer GI have sensing via holes GIV, and the sensing signal line SL is electrically connected to the second metal layer GT through a sensing via hole GIV; the first transistor T1 has a first conductive structure adjacent to the sensing via hole GIV, and the length direction ED of the overlapping via hole GIH of the first conductive structure is perpendicular to the channel region T1CR of the first transistor.

The first transistor T1 has the first conductive structure, the length direction ED of the overlapping via hole GIH of the first conductive structure in the first transistor T1 is perpendicular to the channel region T1CR of the first transistor, and the first transistor T1 is L-shaped. Thus, the space utilization may be improved, the device layout may be achieved, and each transistor TFT may emit light under the driving of the pixel driving circuit PDC.

Optionally, referring to FIG. 19, the length direction ED of the overlapping via hole GIH of the first conductive structure is the row direction DH, and the length direction LE of the channel region T1CR of the first transistor is the column direction DV.

In another embodiment of the present disclosure, referring to FIGS. 3 and 18, the inorganic buffer layer BUF and the gate insulating layer GI have sensing via holes GIV, and the sensing signal line SL is electrically connected to the second metal layer GT through a sensing via hole GIV; the third transistor T3 has a second conductive structure adjacent to the sensing via hole GIV, and the length direction ED of the overlapping via hole GIH of the second conductive structure is perpendicular to the channel region T3CR of the third transistor.

The third transistor T3 has the second conductive structure, the length direction ED of the overlapping via hole GIH of the second conductive structure in the third transistor T3 is perpendicular to the channel region T3CR of the third transistor, and the third transistor T3 is L-shaped. Thus, the space utilization may be improved, the device layout may be achieved, and each transistor TFT may emit light under the driving of the pixel driving circuit PDC.

Optionally, referring to FIG. 18, the length directions ED of the overlapping via holes GIH of the two conductive structures CS in the third transistor T3 are both the column direction DV, and the length direction LE of the channel region T3CR of the third transistor is the row direction DH.

The embodiments of the present disclosure further provide a display apparatus, and the display apparatus includes any display panel described in the above display panel embodiments. The display apparatus may be a smartphone screen, a smartwatch screen, or a display apparatus of another type. Since the display apparatus has any display panel described in the above display panel embodiments, it has the same beneficial effects as the display panel, which will not be repeated here.

Other embodiments of the present disclosure will be easily conceived of by those skilled in the art in consideration of the specification and practicing the invention disclosed herein. The present disclosure is intended to cover any variations, uses or adaptations of the present disclosure. These variations, uses, or adaptations follow the general principles of the present disclosure and include common knowledge or conventional technical means in the art, which is not disclosed in the present disclosure. The specification and the embodiments are only regarded as exemplary, and the true scope and spirit of the present disclosure are set forth according to the claims.

## Claims

1. A display panel, comprising a base substrate, a driving layer and a pixel layer that are stacked in sequence, wherein the driving layer has transistors for driving sub-pixels, and the driving layer includes a first metal layer, a semiconductor layer, a gate insulating layer, a second metal layer and a planarization layer that are stacked in sequence on the base substrate;
at least one of the transistors includes a channel region located in the semiconductor layer, and two conductive structures located on both sides of the channel region; at least one of the conductive structures includes an electrical contact structure located in the semiconductor layer, an overlapping insulation structure located in the gate insulating layer, and an overlapping structure located in the second metal layer;
the overlapping insulation structure has an overlapping via hole, and the overlapping structure is electrically connected to the electrical contact structure through the overlapping via hole; and
a length direction of at least one overlapping via hole of the at least one transistor is non-parallel to a length direction of a channel region of the transistor.

2. The display panel according to claim 1, wherein a length direction of one overlapping via hole of the at least one transistor is perpendicular to the length direction of the channel region of the transistor.

3. The display panel according to claim 1, wherein length directions of two overlapping via holes of the at least one transistor are both perpendicular to the length direction of the channel region of the transistor.

4. The display panel according to claim 1, wherein the overlapping via hole extends to an edge of the overlapping insulation structure and is in an opening structure, and a length direction of the overlapping via hole is an opening direction of the overlapping via hole.

5. The display panel according to claim 1, wherein an orthographic projection of the gate insulating layer on the base substrate does not exceed an orthographic projection of the second metal layer on the base substrate.

6. The display panel according to claim 5, wherein at least one of electrical contact structures has an adjacent region that is exposed by the gate insulating layer and the second metal layer and is adjacent to an overlapping via hole, and a thickness of the semiconductor layer in the adjacent region is less than a thickness of the semiconductor layer in the channel region.

7. The display panel according to claim 6, wherein in a length direction of the overlapping via hole, a size of the adjacent region is less than a size of the overlapping via hole.

8. The display panel according to claim 6, wherein the electrical contact structure includes a first conductive region, a second conductive region and a third conductive region that are connected in sequence; and
the first conductive region is located between the channel region of the transistor and the adjacent region, the second conductive region is located on a side of the adjacent region away from the overlapping via hole, and the third conductive region is located on a side of the adjacent region away from the channel region.

9. The display panel according to claim 1, wherein the driving layer further includes a first metal layer and an inorganic buffer layer located between the base substrate and the semiconductor layer; the inorganic buffer layer is located between the first metal layer and the semiconductor layer; and the first metal layer and the second metal layer are connected through via holes.

10. The display panel according to claim 9, wherein at least one of overlapping via holes further includes a first auxiliary hole covered by the overlapping structure and extending beyond the electrical contact structure; the inorganic buffer layer has a second auxiliary hole aligned with the first auxiliary hole, and the first auxiliary hole and the second auxiliary hole expose at least a portion of the first metal layer; and
the overlapping structure is electrically connected to the first metal layer through the first auxiliary hole and the second auxiliary hole.

11. The display panel according to claim 9, wherein the driving layer has pixel driving circuits for driving the pixel layer; a pixel driving circuit includes a storage capacitor, a first transistor, a second transistor, and a third transistor, and the transistors each include a gate, a first electrode, and a second electrode;
a first electrode of the first transistor is used for loading a driving power supply voltage, a gate of the first transistor is electrically connected to a second electrode of the second transistor and a first electrode plate of the storage capacitor, and a second electrode of the first transistor is electrically connected to a second electrode of the third transistor, a pixel electrode of a sub-pixel and a second electrode plate of the storage capacitor; a first electrode of the third transistor is electrically connected to a sensing signal line; and a first electrode of the second transistor is used for loading a data voltage;
a gate of the second transistor and a gate of the third transistor are used for loading a scan signal;
the inorganic buffer layer and the gate insulating layer have a sensing via hole, and the sensing signal line is electrically connected to the second metal layer through the sensing via hole; and
the first transistor has a first conductive structure adjacent to the sensing via hole, and a length direction of an overlapping via hole of the first conductive structure is perpendicular to a channel region of the first transistor.

12. The display panel according to claim 11, wherein the length direction of the overlapping via hole of the first conductive structure is a row direction; and
a length direction of the channel region of the first transistor is a column direction.

13. The display panel according to claim 9, wherein the driving layer has pixel driving circuits for driving the pixel layer; a pixel driving circuit includes a storage capacitor, a first transistor, a second transistor, and a third transistor, and the transistors each include a gate, a first electrode, and a second electrode;
a first electrode of the first transistor is used for loading a driving power supply voltage, a gate of the first transistor is electrically connected to a second electrode of the second transistor and a first electrode plate of the storage capacitor, and a second electrode of the first transistor is electrically connected to a second electrode of the third transistor, a pixel electrode of a sub-pixel and a second electrode plate of the storage capacitor; a first electrode of the third transistor is electrically connected to a sensing signal line; and a first electrode of the second transistor is used for loading a data voltage;
a gate of the second transistor and a gate of the third transistor are used for loading a scan signal;
the inorganic buffer layer and the gate insulating layer have a sensing via hole, and the sensing signal line is electrically connected to the second metal layer through the sensing via hole; and
the third transistor has a second conductive structure adjacent to the sensing via hole, and a length direction of an overlapping via hole of the second conductive structure is perpendicular to a channel region of the third transistor.

14. The display panel according to claim 13, wherein length directions of overlapping via holes of the two conductive structures in the third transistor are both a column direction; and
a length direction of the channel region of the third transistor is a row direction.

15. A display apparatus, comprising the display panel according to any one of claims 1 to 14.
